Europäisches Patentamt

European Patent Office

Office européen des brevets

(19)

(11) **EP 1 322 036 A1**

(12) **DEMANDE DE BREVET EUROPEEN**

(43) Date de publication:
**25.06.2003 Bulletin 2003/26**

(51) Int Cl.⁷: **H03G 3/30**

(21) Numéro de dépôt: **02080244.3**

(22) Date de dépôt: **11.12.2002**

(84) Etats contractants désignés:
**AT BE BG CH CY CZ DE DK EE ES FI FR GB GR IE IT LI LU MC NL PT SE SI SK TR**
Etats d'extension désignés:
**AL LT LV MK RO**

(30) Priorité: **20.12.2001 FR 0116574**

(71) Demandeur: **Koninklijke Philips Electronics N.V.
5621 BA Eindhoven (NL)**

(72) Inventeur: **Bouvier, Stéphane,
Société Civile S.P.I.D.
75008 Paris (FR)**

(74) Mandataire: **Chaffraix, Jean
Société Civile S.P.I.D.
156, Boulevard Haussmann
75008 Paris (FR)**

(54) **Dispositif comportant un amplificateur symétrique**

(57) Ce dispositif trouve d'importantes applications dans le domaine des circuits d'interface pour fibres optiques. Il est proposé dans ce circuit d'utiliser un amplificateur symétrique (19) auquel on adjoint un circuit de commande automatique de gain (27) qui est insensible aux variations de la tension de décalage de cet amplificateur. Ce circuit de commande (27) comporte des détecteurs de crête qui donnent les meilleurs résultats dans un circuit de ce genre destiné à traiter des signaux à fréquences très rapides.

Application : Interface pour fibres optiques.

FIG.1

EP 1 322 036 A1

**Description**

L'invention concerne un dispositif comportant un amplificateur symétrique muni, entre autres, d'au moins une borne d'entrée pour recevoir une tension à amplifier, d'une paire de bornes de sortie pour fournir une tension amplifiée symétrique et d'un circuit amplificateur symétrique pourvu d'entrées pour être reliées à ladite borne d'entrée et de sorties pour être reliées aux dites bornes de sortie et aussi d'une commande de gain pour recevoir un signal de commande de gain.

L'invention trouve d'importantes applications notamment dans le domaine des fibres optiques qui transmettent à très haute vitesse ($\sim$ 10 Gbit/s). Dans ce domaine, il faut bien prévoir une transformation qui adapte les signaux véhiculés par la fibre optique en des signaux destinés à une ligne à fils électriques. Cette transformation implique des amplifications de type symétrique. On pourra se rapporter à la notice explicative du composant TZA3013A fabriqué par Philips. Pour obtenir une bonne conversion des signaux pour ladite ligne à fils électriques, il est bien connu que l'amplitude des signaux soit bien régulée. Cette régulation est difficilement de bonne qualité, car aux fréquences de travail envisagé, il est difficile d'avoir une bonne mesure de l'amplitude des signaux en sortie de l'amplificateur symétrique, cette mesure étant affectée par les variations de tension de décalage (tension d'offset) dues aux dérives thermiques, au vieillissement, entre autres.

La présente invention propose un dispositif du genre mentionné dans le préambule qui permet d'avoir un gain constant de l'amplitude des signaux destinés aux fils électriques même en présence d'une variation de la tension de décalage.

Pour cela, un tel dispositif est remarquable en ce que ledit amplificateur est muni, en outre, d'un circuit de mesure d'amplitude de signaux pour fournir ledit signal de commande de gain, formé de détecteurs d'amplitude de même type, branchés pour fournir des mesures représentant l'amplitude des grandeurs électriques au niveau desdites bornes de sortie.

L'idée de l'invention consiste à utiliser des détecteurs de même type, par exemple des détecteurs de crête pour mesurer l'amplitude des signaux sur les sorties symétriques de l'amplificateur, et non pas un détecteur de crête pour une sortie et un détecteur de creux (« valley detector » en littérature anglo-saxonne). Ces détecteurs impliquent des transistors de types différents dont il est difficile d'appairer les caractéristiques électriques.

La description suivante, faite en regard des dessins ci-annexés, le tout donné à titre d'exemples non limitatifs fera bien comprendre comment l'invention peut être réalisée.

Sur les dessins :

La figure 1 montre un dispositif conforme à l'invention,
La figure 2 montre un amplificateur faisant partie du dispositif conforme à l'invention,
La figure 3 montre un détecteur d'amplitude mis en oeuvre dans l'amplificateur de l'invention,
La figure 4 montre un diagramme temps destiné à l'explication de l'invention.

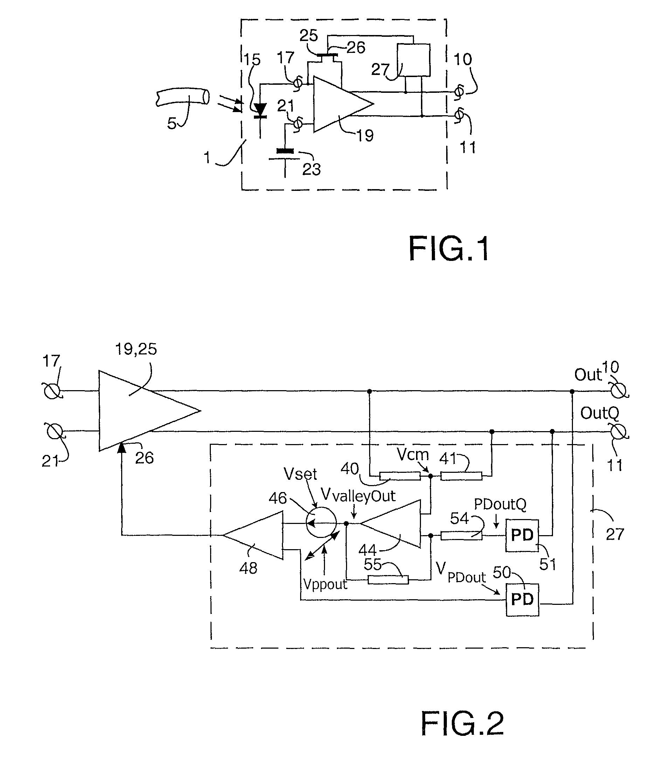

La figure 1 montre un dispositif conforme à l'invention portant la référence 1. Ce dispositif est, dans le cadre de l'exemple, un circuit d'interface pour une fibre optique 5 transmettant des informations. Ces informations sont fournies sous forme de signaux symétriques aux bornes de sortie 10 et 11. Le rayonnement lumineux de la fibre optique 5 est analysé par une diode PIN 15. Les variations de tension aux électrodes de cette diode sont appliquées à une borne d'entrée 17 d'un amplificateur différentiel 19. L'autre borne d'entrée 21 est reliée à une source de tension 23 dont la valeur détermine un seuil pour la détection des données issues de la diode 15. Selon la valeur de ce signal reçu, il est nécessaire de l'amplifier plus ou moins pour un traitement ultérieur. Pour régler cette amplification on agit sur une résistance de contre réaction constituée par un transistor à effet de champ 25 recevant une tension de commande de variation de gain élaborée par un circuit de commande de gain 27. Cette commande de variation de gain, portant la référence 26 est constituée par la grille de ce transistor 25.

La figure 2 montre, plus en détail, ce circuit de commande de gain 27 qui n'est pas affecté par les variations de tension d'offset de l'amplificateur 19. Ce circuit de commande comporte un point de mesure de la tension médiane aux bornes 10 et 11. Il est formé d'un montage en série de deux résistances 40 et 41 monté entre les deux bornes 10 et 11. Le point commun à ces deux résistances est connecté à la première entrée d'un amplificateur 44 dont la sortie est reliée à une source de tension 46 qui superpose, à la tension de sortie de l'amplificateur 44, une tension Vset. Cette tension superposée est appliquée à la première entrée d'un deuxième amplificateur 48 dont la sortie est appliquée à l'entrée de la commande de variation de gain 26. Selon l'une des caractéristiques de l'invention, les deuxièmes entrées des amplificateurs 44 et 48 sont branchées respectivement aux sorties de deux détecteurs d'amplitude 50 et 51 mesurant les tensions aux bornes 10 et 11. La sortie du détecteur 50 est connectée directement à la deuxième entrée de l'amplificateur 48, tandis que celle du détecteur 51 est reliée à la deuxième entrée de l'amplificateur 44 via un réseau de contre réaction formé de deux résistances 54 et 55 d'égale valeur. La sortie du détecteur 51 est reliée à une extrémité de la résistance 54 dont l'autre extrémité est connectée à cette deuxième entrée de l'amplificateur 44. La deuxième résistance 55 interconnecte la sortie avec la deuxième entrée de l'amplificateur 44.

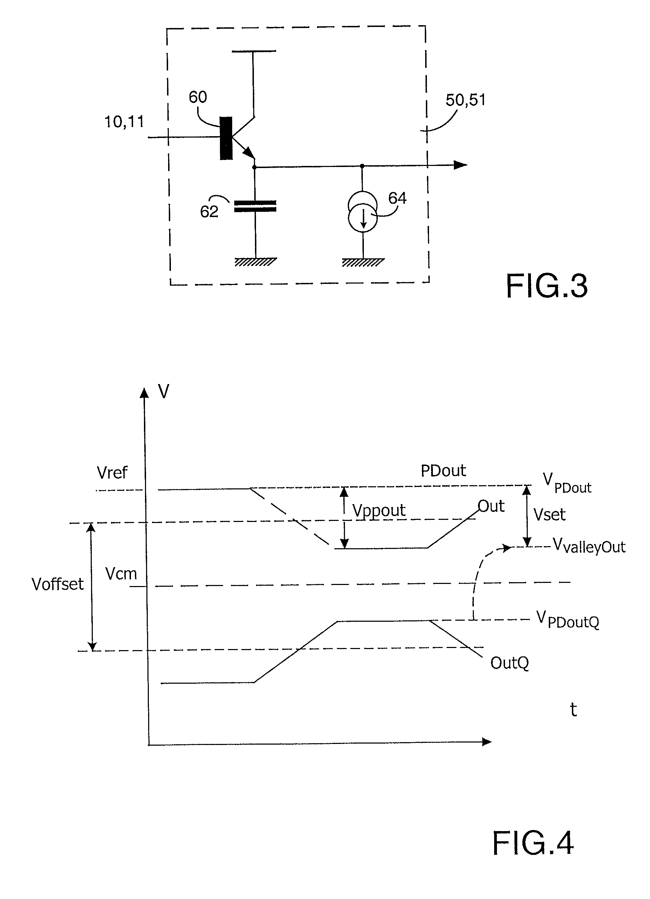

La figure 3 montre en détail comment sont réalisés les détecteurs d'amplitude 50 et 51. Ils se composent d'un transistor 60 dont la base constitue l'entrée de ce détecteur, d'un condensateur 62 qui est branché entre l'émetteur de ce transistor et la masse, le collecteur de ce transistor étant porté à un potentiel de valeur convenable fixe, et d'un générateur de courant 64 qui a pour but de décharger à courant constant le condensateur 62.

On explique dans ce qui suit le fonctionnement du circuit de commande de gain 27 (figure 4) :

- Out est la tension de sortie de l'amplificateur 19 à la borne 10,
- $V_{Pdout}$ est la valeur de la tension crête mesurée par le détecteur 50 correspondant à cette tension Out,
- OutQ est la tension de sortie de l'amplificateur 19 à la borne 11,
- $V_{PdoutQ}$ est la valeur de la tension de crête mesurée par le détecteur 50 correspondant à cette tension Out,
- Vset est la valeur de consigne pour que l'amplitude des signaux Out et OutQ reste asservie à cette valeur,
- Vppout est l'amplitude du signal de sortie qu'il faut asservir sur Vset,
- $V_{valleyOut}$ est la valeur crête correspondant à un détecteur de creux. Elle est obtenue par le détecteur 51 et l'amplificateur 44 inverseur pour la tension de sortie de ce détecteur 51. Ceci est obtenu par la valeur égale des résistances 54 et 55 et aussi par l'application à l'une de ses entrées de la tension des points milieux des résistances 40 et 41.
- Voffset est la tension de décalage qui peut varier en fonction du temps, cette tension représente l'écart en tension qui sépare le niveau moyen des signaux de sortie des signaux Out et OutQ.

Il est possible alors de montrer que :

$$VppOut = Vpeak - Vvalley = Vset.$$

Dans cette formule Vpeak est la valeur maximale de la tension donnée par un détecteur de crête relié à une sortie (10) et Vvalley serait la valeur de l'amplitude minimale du signal à la sortie (11).
Cette formule montre bien que l'amplitude Vppout reste fixée à la valeur Vset et que la tension de décalage Voffset n'intervient pas. L'invention crée donc ce signal Vvalley en utilisant un détecteur de crête 51 combiné avec l'amplificateur 44 et son réseau de contre réaction de façon à former un circuit de simulation de valeur minimale.

**Revendications**

1. Dispositif comportant un amplificateur symétrique muni, entre autres, d'au moins une borne d'entrée pour recevoir une tension à amplifier, d'une paire de bornes de sortie pour fournir une tension amplifiée symétrique et d'un circuit amplificateur symétrique pourvu d'entrées pour être reliées à ladite borne d'entrée et de sorties pour être reliées aux dites bornes de sortie et aussi d'une commande de gain pour recevoir un signal de commande de gain, **caractérisé en ce que** ledit amplificateur est muni, en outre, d'un circuit de mesure d'amplitude de signaux pour fournir ledit signal de commande de gain, formé de détecteurs d'amplitude de même type, branchés pour fournir des mesures représentant l'amplitude des grandeurs électriques au niveau desdites bornes de sortie.

2. Dispositif selon la revendication 1, **caractérisé en ce que** lesdits détecteurs sont du type détecteur de crête dont un est branché sur une des sorties et l'autre sur l'autre sortie, un circuit de simulation de valeur minimale étant inséré à sa sortie.

3. Dispositif selon l'une des revendications 1 ou 2, **caractérisé en ce qu'**il comporte des interfaces pour se connecter à une ligne du type fibre optique.

# FIG.1

# FIG.2

FIG.3

FIG.4

EP 1 322 036 A1

**Office européen des brevets**

**RAPPORT DE RECHERCHE EUROPEENNE**

Numéro de la demande

EP 02 08 0244

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| Y | US 6 084 478 A (MAYAMPURATH BALAGOPAL) 4 juillet 2000 (2000-07-04) * colonne 3, ligne 16 - colonne 4, ligne 59; figure 2 * --- | 1-3 | H03G3/30 |
| Y | US 5 636 048 A (KOGURE KAZUHISA ET AL) 3 juin 1997 (1997-06-03) * colonne 15, ligne 46 - colonne 16, ligne 7; figure 24 * ----- | 1-3 | |
| | | | **DOMAINES TECHNIQUES RECHERCHES (Int.Cl.7)** |
| | | | H03G |

Le présent rapport a été établi pour toutes les revendications

| Lieu de la recherche | Date d'achèvement de la recherche | Examinateur |
|---|---|---|
| LA HAYE | 2 avril 2003 | Tyberghien, G |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)

6

**ANNEXE AU RAPPORT DE RECHERCHE EUROPEENNE
RELATIF A LA DEMANDE DE BREVET EUROPEEN NO.**     EP 02 08 0244

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

02-04-2003

| Document brevet cité au rapport de recherche | | Date de publication | Membre(s) de la famille de brevet(s) | | Date de publication |
|---|---|---|---|---|---|
| US 6084478 | A | 04-07-2000 | AU | 5582199 A | 14-03-2000 |
| | | | EP | 1025639 A1 | 09-08-2000 |
| | | | JP | 2002523952 T | 30-07-2002 |
| | | | WO | 0011780 A1 | 02-03-2000 |
| US 5636048 | A | 03-06-1997 | JP | 8223228 A | 30-08-1996 |
| | | | KR | 144060 B1 | 01-08-1998 |

EPO FORM P0460

Pour tout renseignement concernant cette annexe : voir Journal Officiel de l'Office européen des brevets, No.12/82